# EUROPÄISCHE PATENTANMELDUNG

(11) **EP 4 571 829 A1**
(43) Veröffentlichungstag der Anmeldung: **18.06.2025**
(21) Anmeldenummer: 23217186.8
(22) Anmeldetag: 15.12.2023
(51) Int. Cl.: H01L 23/427, H01L 23/373

(54) **LEISTUNGSBAUSTEIN FÜR EINE ELEKTRONISCHE RECHENEINRICHTUNG, SOWIE ANORDNUNG**

(71) Anmelder: Siemens Aktiengesellschaft, 80333 München (DE)
(72) Erfinder: Bigl, Thomas, 91074 Herzogenaurach (DE); Heimann, Matthias, 14469 Potsdam (DE); Hensler, Alexander, 91466 Gerhardshofen (DE); Müller, Bernd, 16259 Falkenberg (DE); Pfeifer, Markus, 90455 Nürnberg (DE); Stencel, Lisa, 10553 Berlin (DE); Strogies, Jörg, 14163 Berlin (DE)
(74) Vertreter: Siemens Patent Attorneys

(57) **Zusammenfassung**

Die Erfindung betrifft einen Leistungsbaustein (12) für eine elektronische Recheneinrichtung, mit zumindest einem Leistungschip (18), welcher im Betrieb Wärme erzeugt, wobei der Leistungsbaustein (12) als Oberflächen-montierbares Bauteil (20) ausgebildet ist, dadurch gekennzeichnet, dass an einer Seite des Leistungschips (18) zumindest eine erste Dampfkammereinrichtung (22) ausgebildet ist, wobei der Leistungschip (18) und zumindest die erste Dampfkammereinrichtung (22) als gemeinsamen Oberflächen-montierbares Bauteil (20) ausgebildet sind. Ferner betrifft die Erfindung eine Anordnung (10).

## Beschreibung

Die Erfindung betrifft einen Leistungsbaustein für eine elektronische Recheneinrichtung, mit zumindest einem Leistungschip, welcher im Betrieb Wärme erzeugt, wobei der Leistungsbaustein als Oberflächen-montierbares Bauteil ausgebildet ist. Ferner betrifft die Erfindung eine Anordnung.

Leistungselektronische Komponenten sind zunehmend durch extreme Leistungsdichten gekennzeichnet. Das bedingt die Herausforderung einer effektiven Abfuhr der entstehenden Verlustwärme. Einseitige Kühllösungen kommen infolge dieser Entwicklung zunehmend an ihre Einsatzgrenzen.

Die Problemstellungen werden aktuell bei einseitiger Kühlung durch entsprechende Auslegung gelöst. Dies kollidiert aber mit den konstruktiven und technologischen Anforderungen hin zu miniaturisierten Komponenten. Die Steigerung der Wärmeabfuhr im Allgemeinen wird durch doppelseitige Kühlkonzepte wesentlich gesteigert. Die dafür notwendigen beidseitigen angeordneten Wärmeflusspfade sind mit entsprechenden Kühlkörpern ausgebildet und führen zu erheblichen Einschränkungen im Gesamtsystemaufbau und lassen insbesondere auch die Anwendung von hochminiaturisierten Komponenten und die Zusammenführung von Leistungs- und Logikfunktionen auf gemeinsamen Motherboards nur unter erheblichen Aufwänden zu.

Aufgabe der vorliegenden Erfindung ist es einen Leistungsbaustein sowie eine Anordnung zu schaffen, welche einfach hergestellt werden kann und dennoch zuverlässig eine Entwärmung des Leistungschips realisiert werden kann.

Diese Aufgabe wird durch einen Leistungsbaustein sowie durch eine Anordnung gemäß den unabhängigen Patentansprüchen gelöst. Vorteilhafte Ausgestaltungsformen sind in den Unteransprüchen angegeben.

Ein Aspekt der Erfindung betrifft einen Leistungsbaustein für eine elektronische Recheneinrichtung, mit zumindest einem Leistungschip, welcher im Betrieb Wärme erzeugt, wobei der Leistungsbaustein als Oberflächen-montierbares Bauteil ausgebildet ist.

Es ist dabei vorgesehen, dass an einer Seite des Leistungschips zumindest eine erste Dampfkammereinrichtung ausgebildet ist, wobei der Leistungschip und die Dampfkammereinrichtung als gemeinsames Oberflächen-montierbares Bauteil ausgebildet sind.

Insbesondere ermöglicht somit die Erfindung das Zusammenführen der Vorteile der bisherigen einseitigen und doppelseitigen Kühlkonzepte, indem eine hohe thermische Performance aufgrund multipler Entwärmungspfade erreicht und dennoch eine einfache Systemintegration ermöglicht wird. Der Einsatz der Dampfkammereinrichtung, welcher auch als Vapour Chamber bezeichnet wird, ermöglicht zudem eine wesentlich effizientere Wärmespreizung und somit homogenere Wärmeverteilung und schnellere Wärmeabfuhr im Gegensatz zu passiven Materialien. Für eine miniaturisierte Aufbauweise mit hoher Ausbeute im Rahmen des Herstellungsprozesses, ist im Stand der Technik der Einsatz von Zwischenverdrahtungsträgern, insbesondere sogenannte Interposern notwendig. Dieser Aufbau wird anschließend über underfilling verkapselt, um als eigenständige, elektrisch vermessbare Einheit in mehrfacher Ausführung auf einem motherboard zusammengeführt zu werden.

Erfindungsgemäß ist hier nun vorgeschlagen, dass die Konzepte vereint werden insbesondere wird eine semi-doppelseitige Kühlung unter Nutzung von ultradünnen Dampfkammereinrichtungen mit den Vorteilen eines sogenannten gemeldeten Oberflächenmontierbaren Bauteils vereint.

Das Oberflächen-montierbare Bauteil wird insbesondere auch als surface-mounted-device (SMD) bezeichnet. Bei diesen SMD-Bauelementen handelt es sich insbesondere um Bauelemente der Oberflächenmontage, wobei die bedrahteten Bauelemente keine Drahtanschlüsse, sondern mittels lötfähiger Anschlussflächen oder -beinchen direkt auf eine Leiterplatte gelötet werden können. Die dazugehörige Technik wird auch als Oberflächenmontage (surface-mounting technology SMT) bezeichnet. Hierbei handelt es sich um eine hochperformante Herstellungsmethodik, welche insbesondere den Bau einer Vielzahl von Elementen ermöglicht.

Insbesondere zur Abschirmung gegenüber Umwelteinflüssen aber auch zur thermomechanischen Stabilisierung und zur Gewährleistung der elektrischen Isolation unter hohen elektrischen Spannungen können im Rahmen dieses Konzepts Verkapselungen durch "molding" realisiert werden. Durch den Verguss des Aufbaus durch Prozesse wie Compressionmolding oder Transfermolding kann auf die Nutzung von Zwischenverdrahtungsträgern, insbesondere den Interposern, und die Anwendung von underfilling verzichtet werden, da das Oberflächen-montierbare Bauteil bereits als eigenständig elektrisch vermessbare und handhabbare Einheit gilt. Dies bedeutet zum einen eine Strukturvereinfachung durch Eliminierung des Interposers als auch eine Effizienzsteigerung im Prozess, da die Verkapselung durch underfilling im Allgemeinen bei größeren Bauräumen zeitintensiv ist. Aus den genannten Gründen wird ein erhebliches Rationalisierungspotenzial verglichen mit dem bisherigen Konzept realisiert.

Das vorgeschlagene Konzept vereint dabei, wie bereits erwähnt, die vorteilhafte und effiziente Entwärmung des Leistungschips über die Seitenflächen unter Zusammenführung in ein miniaturisiertes surface-mounted-device.

Wesentliche Vorteile der beschriebenen Lösungen bestehen in der Kombination aus semi-doppelseitiger Kühlung und der Realisierung dieser in einem hochminiaturisierten SMD-Packlage unter starker Vereinfachung der Gesamtkonstruktion und der damit verbundenen Fertigungsschritte. Durch die Funktionsintegration der miniaturisierten Dampfkammereinrichtung kann mit diesen Konstruktionselementen zugleich die Funktion der elektrischen Anbindung und an den von außen zugänglichen Bereichen die Funktion der SMD-Pads realisiert werden. Weiterhin erlaubt die Aufbauweise sehr effiziente Verkapselungsverfahren mittels Molding-Prozesse. Zumindest anteilig können Fertigungsschritte auch im Nutzenverbund erfolgen.

Gemäß einer vorteilhaften Ausgestaltungsform ist der Leistungsbaustein als Quad-Flat-No-Leads-Package Bauteil ausgebildet. Hierbei handelt es sich insbesondere um ein sogenannte QFN-pack. Dies ist insbesondere als Untergruppe der SMD-Bauteile anzusehen. Die Quad-Flat-No-Leads-Package werden auch micro lead frame packages(MLF) bezeichnet, und ist eine Elektronik gebräuchliche Chipgehäusebauform für integrierte Schaltungen. Die Bezeichnung umfasst dabei unterschiedliche Größen von IC (Integrated Circuit)-Gehäusen, welche alle als Oberflächen-montierbare Bauteile auf Leiterplatten gelötet werden. Als wesentliche Merkmale im Gegensatz zu den beispielsweise Quad-Flat-Package (QFP) ragen die elektrischen Anschlüsse, insbesondere die sogenannten Pins, im Wesentlichen nicht seitlich über die Abmessungen der Kunststoffummantelung hinaus, sondern sind in Form von teilverzinnten Kupferanschlüssen plan in die Unterseite des Gehäuses integriert. Dadurch kann der nötige Platz auf der Leiterplatte reduziert und eine höhere Packungsdichte erreicht werden.

Weiterhin vorteilhaft ist, wenn der Leistungschip im Wesentlichen quaderförmig ausgebildet ist. Somit kann eine einfache Form für den Leistungschip bereitgestellt werden. Des Weiteren weist der Leistungschip dann im Wesentlichen sechs Seiten auf, und kann beispielsweise über unterschiedliche Seiten entwärmt werden.

Es hat sich weiterhin als vorteilhaft erwiesen, wenn gegenüberliegend von der ersten Dampfkammereinrichtung eine zweite Dampfkammereinrichtung an dem Leistungschip angeordnet ist. Somit kann über eine zweite Seite der Leistungschip entwärmt werden. Dies führt zu einer Leistungssteigerung des Leistungschips, wodurch insbesondere eine erhöhte Leistungsfähigkeit durch den Leistungschip bereitgestellt werden kann.

Ebenfalls vorteilhaft ist, wenn der Leistungsbaustein an einer dritten Seite des Leistungschips eine dritte Dampfkammereinrichtung aufweist. Dabei kann die dritte Seite beispielsweise rechtwinklig zur Seite mit der ersten Dampfkammereinrichtung ausgebildet sein. Somit kann eine dritte Dampfkammereinrichtung bereitgestellt werden, wodurch eine noch höhere Entwärmung realisiert werden kann.

Eine weitere vorteilhafte Ausgestaltungsform sieht vor, dass der Leistungsbaustein an einer vierten Seite des Leistungschips eine vierte Dampfkammereinrichtung aufweist. Die vierte Seite ist dabei bevorzugt beispielsweise der dritten Seite gegenüberliegend ausgebildet. Somit kann der Leistungsbaustein mit vier Seiten entsprechend gekühlt werden, wodurch eine erhöhte Leistungsfähigkeit realisiert werden kann.

Eine weitere vorteilhafte Ausgestaltungsform sieht vor, dass der Leistungsbaustein an einer Oberseite des Leistungschips zumindest eine fünfte Dampfkammereinrichtung aufweist. Insbesondere können beispielsweise an einer Oberseite des Leistungschips entsprechende elektronische Anschlusselemente, wie beispielsweise Gateanschluss oder Sourceanschluss bereitgestellt werden. Insbesondere können dann Gate und Source jeweils mit unterschiedlichen Dampfkammereinrichtungen gekühlt werden, da diese insbesondere dann elektrisch voneinander zu isolieren sind. Somit können die einzelnen Bauteile zusätzlich über die Oberseite entsprechend gekühlt werden, wodurch eine verbesserte Entwärmung des Leistungsbausteins beziehungsweise des Leistungschips realisiert werden kann.

In einer weiteren vorteilhaften Ausgestaltungsform ist vorgesehen, dass der Leistungschip mit einer Unterseite des Leistungschips an einer Fügezone angeordnet ist, wobei der Leistungschips und die Fügezone als Oberflächen-montierbares Bauteil ausgebildet sind. Somit kann auf einfache Art und Weise ein Oberflächen-montierbares Bauteil bereitgestellt werden.

Ferner hat es sich als vorteilhafte erwiesen, wenn der Leistungsbaustein eine metallische Komponente aufweist und die Fügezone mit der metallischen Komponente verbunden ist. Die metallische Komponente kann somit insbesondere dazu ausgebildet sein, beispielsweise den Wärmeübertrag aus der ersten Dampfkammereinrichtung aufzunehmen und beispielsweise von dem Leistungschip abzuführen. Insbesondere ist die metallische Komponente dann in Richtung eines Kühlkörpers einer Anordnung mit dem Leistungsbaustein ausgebildet, wodurch ein Wärmepfad zum Kühlkörper realisiert werden kann.

Dabei hat es sich weiterhin als vorteilhaft erwiesen, wenn die metallische Komponente aus Kupfer ausgebildet ist. Kupfer bildet dabei eine metallische Komponente mit einem sehr hohen Wärmeleitkoeffizienten. Des Weiteren ist Kupfer bereits etabliert. Somit kann auf einfache Art und Weise eine Entwärmung des Leistungschips realisiert werden.

Es hat sich weiterhin als vorteilhaft erwiesen, wenn die metallische Komponente mit einer Isolationsschicht verbunden ist. Die Isolationsschicht dient insbesondere dazu, dass die metallische Komponente elektrisch isoliert ist. Somit können entsprechende elektrische Überschläge von beispielsweise einer Kühlseite zu dem Leistungschip verhindert werden. Somit können Kurzschlüsse verhindert werden wodurch ein zuverlässiger Betrieb des Leistungsbausteins realisiert werden kann.

Dabei hat es sich weiterhin als vorteilhaft erwiesen, wenn die Isolationsschicht aus einer Keramik ausgebildet ist. Insbesondere Keramik weist einen hohen Wärmeleitkoeffizienten sowie eine hohe elektrische Isolationsfähigkeit auf. Somit kann sowohl eine elektrische Isolation sowie eine vorteilhafte Wärmeabfuhr von der metallischen Komponente in Richtung eines Kühlkörpers realisiert werden.

Gemäß einer weiteren vorteilhaften Ausgestaltungsform ist die Isolationsschicht mit einer weiteren metallischen Komponente verbunden. Dabei kann die weitere metallische Komponente beispielsweise ebenfalls aus Kupfer ausgebildet sein. Die weitere metallische Komponente kann dann wiederum in Kontakt mit dem Kühlkörper stehen. Somit kann zuverlässig ein Wärmeabfuhrpfad vom Leistungsbaustein zum Kühlkörper hin realisiert werden.

Ein weiterer Aspekt der Erfindung betrifft eine Anordnung mit einem Kühlkörper und mit einem Leistungsbaustein nach dem vorhergehenden Aspekt.

Gemäß einer vorteilhaften Ausgestaltungsform der Anordnung ist vorgesehen, dass auf einer dem Kühlkörper abgewandten Seite der Anordnung der Leistungsbaustein mit einer Leiterplatte gekoppelt ist. Insbesondere können dann entsprechende Anschlüsse des Leistungsbausteins über die Leiterplatte realisiert werden.

Ebenfalls betrifft die Erfindung noch eine elektronische Recheneinrichtung mit zumindest einer Anordnung nach dem vorhergehenden Aspekt.

Vorteilhafte Ausgestaltungsformen des Leistungsbausteins sind als vorteilhafte Ausgestaltungsformen der Anordnung sowie der elektronischen Recheneinrichtung anzusehen.

Unter einer Recheneinheit kann insbesondere ein Datenverarbeitungsgerät verstanden werden, das einen Verarbeitungsschaltkreis enthält. Die Recheneinheit kann also insbesondere Daten zur Durchführung von Rechenoperationen verarbeiten. Darunter fallen gegebenenfalls auch Operationen, um indizierte Zugriffe auf eine Datenstruktur, beispielsweise eine Umsetzungstabelle, LUT (englisch: "look-up table"), durchzuführen.

Die Recheneinheit kann insbesondere einen oder mehrere Computer, einen oder mehrere Mikrocontroller und/oder einen oder mehrere integrierte Schaltkreise enthalten, beispielsweise eine oder mehrere anwendungsspezifische integrierte Schaltungen, ASIC (englisch: "application-specific integrated circuit"), eines oder mehrere feldprogrammierbare Gate-Arrays, FPGA, und/oder eines oder mehrere Einchipsysteme, SoC (englisch: "system on a chip"). Die Recheneinheit kann auch einen oder mehrere Prozessoren, beispielsweise einen oder mehrere Mikroprozessoren, eine oder mehrere zentrale Prozessoreinheiten, CPU (englisch: "central processing unit"), eine oder mehrere Grafikprozessoreinheiten, GPU (englisch: "graphics processing unit") und/oder einen oder mehrere Signalprozessoren, insbesondere einen oder mehrere Digitalsignalprozessoren, DSP, enthalten. Die Recheneinheit kann auch einen physischen oder einen virtuellen Verbund von Computern oder sonstigen der genannten Einheiten beinhalten.

In verschiedenen Ausführungsbeispielen beinhaltet die Recheneinheit eine oder mehrere Hardware- und/oder Softwareschnittstellen und/oder eine oder mehrere Speichereinheiten.

Eine Speichereinheit kann als flüchtiger Datenspeicher, beispielsweise als dynamischer Speicher mit wahlfreiem Zugriff, DRAM (englisch: "dynamic random access memory") oder statischer Speicher mit wahlfreiem Zugriff, SRAM (englisch: "static random access memory"), oder als nicht-flüchtiger Datenspeicher, beispielsweise als Festwertspeicher, ROM (englisch: "read-only memory"), als programmierbarer Festwertspeicher, PROM (englisch: "programmable read-only memory"), als löschbarer programmierbarer Festwertspeicher, EPROM (englisch: "erasable programmable read-only memory"), als elektrisch löschbarer programmierbarer Festwertspeicher, EEPROM (englisch: "electrically erasable programmable read-only memory"), als Flash-Speicher oder Flash-EEPROM, als ferroelektrischer Speicher mit wahlfreiem Zugriff, FRAM (englisch: "ferroelectric random access memory"), als magnetoresistiver Speicher mit wahlfreiem Zugriff, MRAM (englisch: "magnetoresistive random access memory") oder als Phasenänderungsspeicher mit wahlfreiem Zugriff, PCR_AM (englisch: "phase-change random access memory"), ausgestaltet sein.

Unabhängig vom grammatikalischen Geschlecht eines bestimmten Begriffes sind Personen mit männlicher, weiblicher oder anderer Geschlechteridentität mit umfasst.

Weitere Merkmale und Merkmalskombinationen der Erfindung ergeben sich aus den Figuren und deren Beschreibung sowie aus den Ansprüchen. Insbesondere müssen weitere Ausführungsformen der Erfindung nicht unbedingt alle Merkmale eines der Ansprüche enthalten. Weitere Ausführungsformen der Erfindungen können Merkmale oder Merkmalskombinationen aufweisen, die nicht in den Ansprüchen genannt sind.
FIG 1 eine schematische Seitenansicht einer Ausführungsform einer Anordnung mit einer Ausführungsform eines Leistungsbausteins;
FIG. 2 eine schematische Seitenansicht einer Ausführungsform eines Leistungsbausteins;
FIG. 3 eine weitere schematische Seitenansicht in Explosionsdarstellung gemäß einer Ausführungsform einer Anordnung; und
FIG. 4 eine weitere schematische Seitenansicht einer Explosionsdarstellung einer Ausführungsform einer Anordnung.

Die Erfindung wird im Folgenden anhand konkreter Ausführungsbeispiele und zugehöriger schematischer Zeichnungen näher erläutert. In den Figuren können gleiche oder funktionsgleiche Elemente mit denselben Bezugszeichen versehen sein. Die Beschreibung gleicher oder funktionsgleicher Elemente wird gegebenenfalls nicht notwendigerweise bezüglich verschiedener Figuren wiederholt.

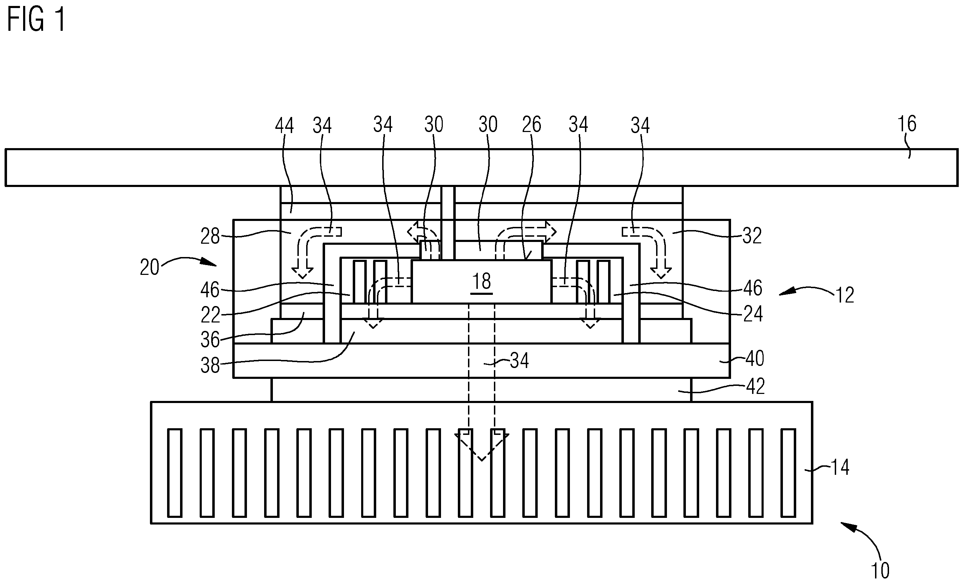

FIG. 1 zeigt eine schematische Seitenansicht einer Ausführungsform einer Anordnung 10. Die Anordnung 10 weist zumindest einen Leistungsbaustein 12, einen Kühlkörper 14 sowie eine Leiterplatte 16 auf. FIG. 1 zeigt insbesondere den Leistungsbaustein 12 für eine nicht dargestellte elektronische Recheneinrichtung. Der Leistungsbaustein 12 weist dabei zumindest einen Leistungschip 18 auf, welcher im Betrieb Wärme erzeugt. Dabei ist insbesondere vorgesehen, dass der Leistungsbaustein 12 als Oberflächen-montierbares Bauteil 20 ausgebildet ist.

Es ist dabei vorgesehen, dass an einer Seite des Leistungschips 18 zumindest eine erste Dampfkammereinrichtung 22 vorgesehen ist, wobei der Leistungschip 18 und die erste Dampfkammereinrichtung 22 als gemeinsames Oberflächen-montierbares Bauteil 20 ausgebildet sind.

Dabei ist insbesondere vorgesehen, dass der Leistungsbaustein 12 als Quat-Flat-No-Leads-Package Bauteil ausgebildet ist.

Ferner zeigt die FIG. 1 dass der Leistungschip 18 im Wesentlichen quaderförmig ausgebildet ist. Ferner ist insbesondere gezeigt, dass gegenüberliegend von der ersten Dampfkammereinrichtung 22 eine zweite Dampfkammereinrichtung 24 an dem Leistungschip 18 angeordnet ist. Ferner kann der Leistungsbaustein 12 an einer dritten Seite des Leistungschips 18 eine dritte Dampfkammereinrichtung aufweisen. Die dritte Seite befindet sich im vorliegenden Ausführungsbeispiel insbesondere in der Zeichenebene. Des Weiteren kann noch vorgesehen sein, dass der Leistungsbaustein 12 an einer vierten Seite des Leistungschips 18 eine vierte Dampfkammereinrichtung aufweist, wobei sich die vierte Seite wiederum vor der Zeichenebene befindet.

Insbesondere zeigt die FIG. 1 ferner, dass der Leistungsbaustein 12 an einer Oberseite 26 des Leistungschips 18 zumindest eine fünfte Dampfkammereinrichtung 28 aufweisen kann. Vorliegend sind insbesondere entsprechende elektronische Anschlüsse 30 auf der Oberseite 26 angeordnet. Beispielsweise kann es sich bei den Anschlüssen 30 um Source- und Gateanschlüsse handeln. Diese sind insbesondere elektronisch beziehungsweise elektrisch voneinander zu trennen. Daher kann auch vorgesehen sein, dass auf der Oberseite 30 eine sechste Dampfkammereinrichtung 32 vorgesehen ist. Ferner sind die Bauteile 30 über die Dampfkammereinrichtungen 28, 32 ebenfalls elektrisch getrennt.

Die FIG. 1 zeigt ferner entsprechende Entwärmungspfade 34, welche vorliegend über Pfeile dargestellt sind.

Des Weiteren ist gezeigt, dass der Leistungschip 18 mit einer Unterseite des Leistungschips 18 an einer Fügezone 36 angeordnet ist, wobei der Leistungschip 18 und die Fügezone 36 dabei beispielsweise als Oberflächen-montierbares Bauteil ausgebildet sind.

Ferner kann vorgesehen sein, dass der Leistungsbaustein 12 eine metallische Komponente 38 aufweist und die Fügezone 36 mit der metallischen Komponente 38 verbunden ist. Die metallische Komponente 38 kann dabei beispielsweise aus Kupfer ausgebildet sein. Ferner kann vorgesehen sein, dass die metallische Komponente 38 mit einer Isolationsschicht 40 verbunden ist. Die Isolationsschicht 40 kann dabei beispielsweise aus Keramik ausgebildet sein. Des Weiteren kann die Isolationsschicht 40 mit einer weiteren metallischen Komponente 42 verbunden sein, welche beispielsweise ebenfalls aus Kupfer ausgebildet ist.

Ferner zeigt die FIG. 1, dass beispielsweise über eine Löt-/Sinterverbindung 44 der Leistungsbaustein 12 an der Leiterplatte 16 angebunden sein kann. Ferner ist insbesondere eine räumliche und elektrische Trennung 46 gezeigt, welche insbesondere die einzelnen Dampfkammereinrichtungen 22, 24, 28, 32 voneinander räumlich und elektrisch trennt.

Insgesamt zeigt somit die FIG. 1, dass das vorgeschlagene Konzept wiederum die Vorteile der semi-doppelseitigen Kühlung unter Nutzung ultradünnen Dampfkammereinrichtungen 22, 24, 28, 32 mit den Vorteilen eines gemeldeten Quad-Flat-No-Leads-Package vereint. Zur Abschirmung gegenüber Umwelteinflüssen aber auch zur thermomechanischen Stabilisierung und zur Gewährleistung der elektrischen Isolation unter hohen elektrischen Spannungen können im Rahmen dieses Konzepts Verkapselungen durch molding realisiert werden. Durch den Verguss des Aufbaus durch Prozesse wie Compression oder Transfermolding kann auf die Nutzung von Zwischenverdrahtungsträgern, insbesondere sogenannten Interposern, und die Anwendung von unterfilling verzichtet werden, da das QFN-package bereits als eigenständig elektrisch vermessbare und handhabbare Einheit gilt. Dies bedeutet zum einen eine Strukturvereinfachung durch Eliminierung des Interposers als auch eine Effizienzsteigerung im Prozess, da die Verkapselung durch underfill im Allgemeinen bei großen bauraum- und zeitintensiv ist. Aus den genannten Gründen wird ein erhebliches Rationalisierungspotenzial verglichen mit dem bisherigen Konzept realisiert.

Das vorgeschlagene Konzept vereint dabei die Vorteile der effizienten Entwärmung des Leistungschips 18 über deren Seitenflächen und Oberseiten und die Zusammenführung in einem miniaturisierten surface-mounted device (SMD) bevorzugt als QFN-Bauform.

Dabei können die Dampfkammereinrichtungen 22, 24, 28, 32 als separate Dampfkammereinrichtungen 22, 24, 28, 32 ausgebildet sein. Bevorzugt und alternativ sind die Dampfkammereinrichtungen 22, 24, 28, 32 als eine gemeinsame Dampfkammereinrichtung 22, 24, 28, 32 ausgebildet und bilden beispielsweise eine rahmenförmige Struktur um den Leistungschip 18.

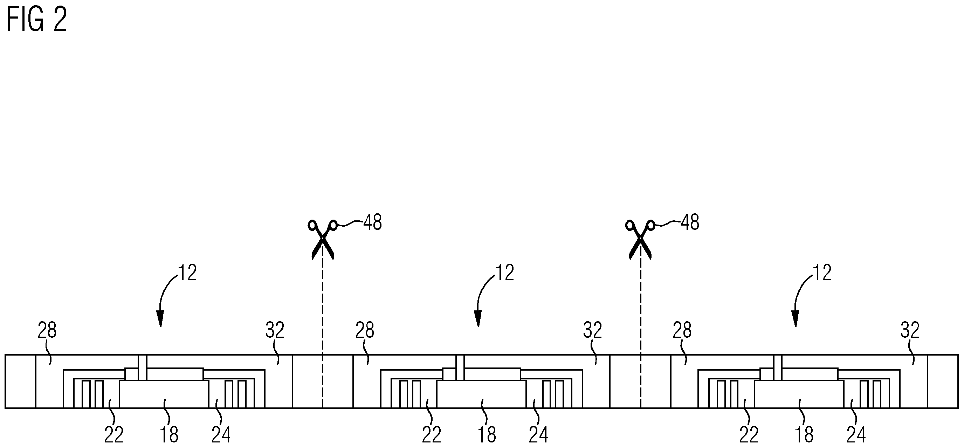

FIG. 2 zeigt eine schematische Ansicht von einer Vielzahl von Leistungsbausteinen 12, welche insbesondere gemeinsam hergestellt werden, und beispielsweise durch Sägen 48 voneinander getrennt werden können. Insbesondere zeigt die FIG. 2 dass die Umsetzung der Kühlungsanordnung in einem hochminiaturisierten package in Form eines QFN realisiert werden kann. Prinzipiell sind dabei verschiedene Pfade zur effizienten Prozessierung denkbar. Die FIG. 2 zeigt dabei eine Möglichkeit in der Vorfertigung des Chipmoduls, wobei dieses bereits die seitlichen und oberseitigen Dampfkammereinrichtungen 22, 24, 28, 32 und deren Verbindungen zum Leistungschip 18 beinhaltet. Vorteilhaft ist in diesem Zusammenhang die Fertigung eines größeren Nutzens von gemeldeten Chipmodulen, da insbesondere das gemeinsame Molding technologische Vorteile bietet. Die Vereinzelung der Chipmodule aus dem Nutzen kann mittels Sägen 48 erfolgen.

Hierbei kann es vorkommen, dass die Fügestellen zum vorzugsweise keramischen Substrat nach ihrer Fertigstellung einen Restspalt zwischen Substratoberfläche und Vergussmassen bedingen. Dieser Restspalt muss nachfolgend entweder mit einem geeigneten Material geschlossen werden oder dass Design unter Berücksichtigung dieses Restspalts geometrisch ausgelegt werden.

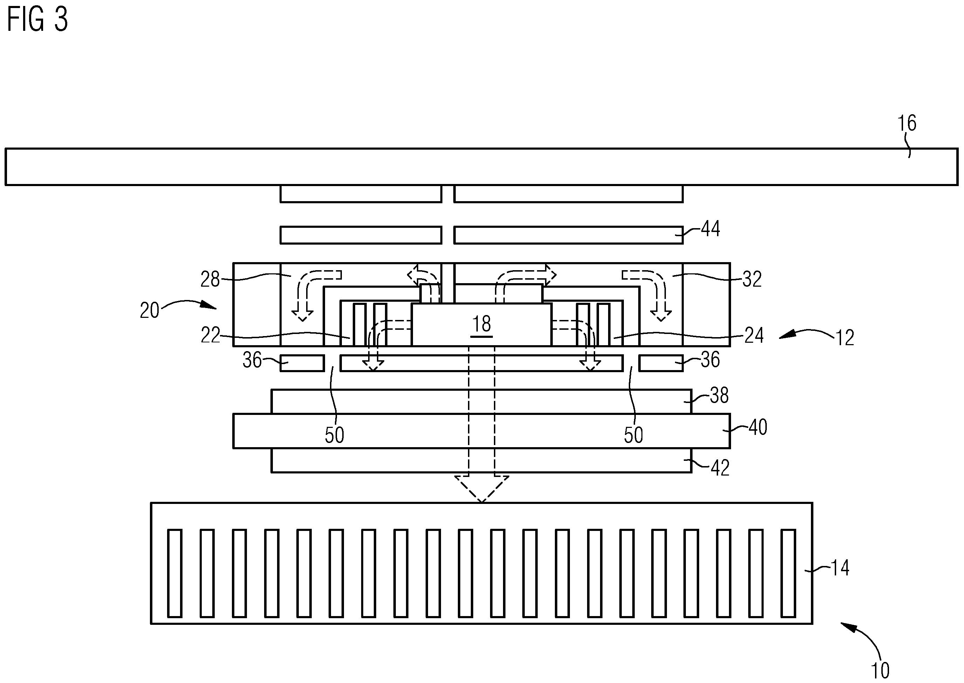

FIG. 3 zeigt eine schematische Seitenansicht einer Ausführungsform der Anordnung 10, insbesondere in einer Explosionsdarstellung. Hierbei ist insbesondere der Ansatz zur Restspaltschließung gezeigt, wobei die Integration über einen Fügeprozess beim Sintern realisiert werden kann, wobei beispielsweise Prepregs oder Polysiloxanfolien simultan appliziert werden können. Dabei ist im folgenden Ausführungsbeispiel insbesondere das Oberflächen-montierbare Bauteil 20 gezeigt, wie es in der FIG. 2 dargestellt ist. Ferner ist ein Restspalt 50 innerhalb der Fügezone 36 gezeigt.

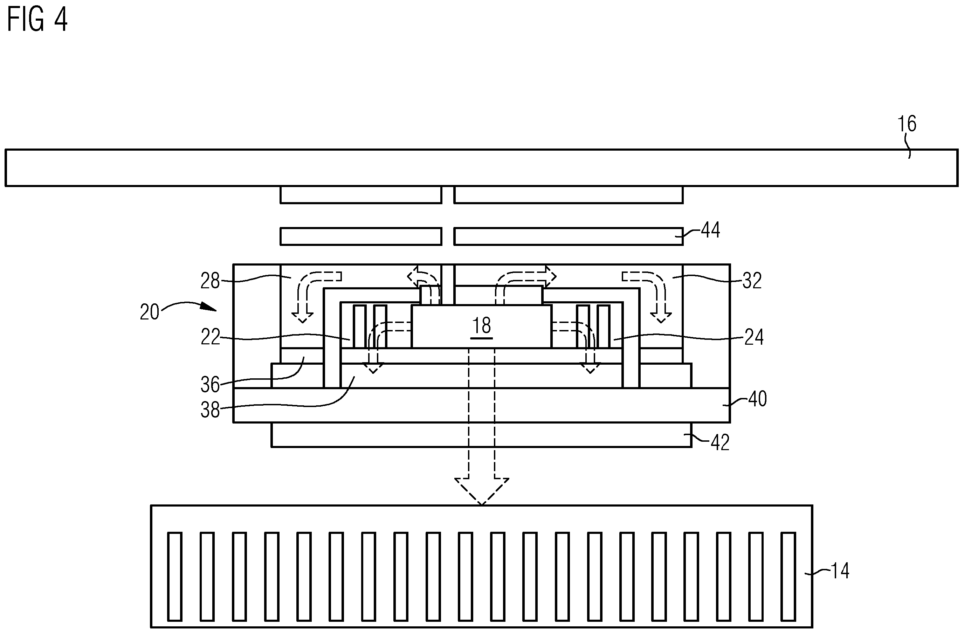

FIG. 4 zeigt eine weitere schematische Seitenansicht einer Ausführungsform des Leistungsbausteins 12 beziehungsweise der Anordnung 10. Hierbei ist insbesondere gezeigt, dass im folgenden Ausführungsbeispiel das Oberflächen-montierbare Bauteil 20 sowohl die Chipstruktur aus der FIG. 2 und FIG. 3 umfasst sowie die Fügezone 36, die metallische Komponente 38, die Isolationsschicht 40 sowie die weitere metallische Komponente 42 umfasst.

Insbesondere zeigt somit die FIG. 4 eine weitere Möglichkeit in der Fertigung der einzelnen Chipmodule zunächst auf der Basis des zum Beispiel keramischen Substrats. Hierbei würden die Fügezonen der Chiprückseiten, der Chipoberseiten und der seitlichen Anbindung an die umlaufende Dampfkammereinrichtung 22, 24, 28, 32 zunächst realisiert. Anschließend erfolgt das Ummolden der Anordnung, wobei die Mold-cap direkt und ohne Restspalt 50 an die Oberseite des Chipträgersubstrats anschließt. Bei dieser Variante müsste das Mold-Werkzeug komplexer gestaltet werden, um eine Nutzenfertigung zu ermöglichen, dafür entfällt die Herausforderung des Restspalts 50.

### Bezugszeichenliste

- 10: Anordnung
- 12: Leistungsbaustein
- 14: Kühlkörper
- 16: Leiterplatte
- 18: Leistungschip
- 20: Oberflächen-montierbares Bauteil
- 22: erste Dampfkammereinrichtung
- 24: zweite Dampfkammereinrichtung
- 26: Oberseite
- 28: dritte Dampfkammereinrichtung
- 30: elektronische Anschlüsse
- 32: vierte Dampfkammereinrichtung
- 34: Wärmepfad
- 36: Fügezone
- 38: metallische Komponente
- 40: Isolationsschicht
- 42: weitere metallische Komponente
- 44: Löt-/Sinterverbindung
- 46: elektrische Isolation
- 48: Sägen
- 50: Restspalt

## Patentansprüche

1. Leistungsbaustein (12) für eine elektronische Recheneinrichtung, mit zumindest einem Leistungschip (18), welcher im Betrieb Wärme erzeugt, wobei der Leistungsbaustein (12) als Oberflächen-montierbares Bauteil (20) ausgebildet ist, **dadurch gekennzeichnet, dass** an einer Seite des Leistungschips (18) zumindest eine erste Dampfkammereinrichtung (22) ausgebildet ist, wobei der Leistungschip (18) und zumindest die erste Dampfkammereinrichtung (22) als gemeinsamen Oberflächen-montierbares Bauteil (20) ausgebildet sind.

2. Leistungsbaustein (12) nach Anspruch 1, **dadurch gekennzeichnet, dass** der Leistungsbaustein (12) als Quad-Flat-No-Leads-Package Bauteil ausgebildet ist.

3. Leistungsbaustein (12) nach Anspruch 1 oder 2, **dadurch gekennzeichnet, dass** der Leistungschip (18) im Wesentlichen quaderförmig ausgebildet ist.

4. Leistungsbaustein (12) nach Anspruch 3, **dadurch gekennzeichnet, dass** gegenüberliegend von der ersten Dampfkammereinrichtung (22) eine zweite Dampfkammereinrichtung (24) an dem Leistungschip (18) angeordnet ist.

5. Leistungsbaustein (12) nach einem der Ansprüche 3 oder 4, **dadurch gekennzeichnet, dass** der Leistungsbaustein (12) an einer dritten Seite des Leistungschips (18) eine dritte Dampfkammereinrichtung aufweist.

6. Leistungsbaustein (12) nach einem der Ansprüche 3 bis 5, **dadurch gekennzeichnet, dass** der Leistungsbaustein (12) an einer vierten Seite des Leistungschips (18) eine vierte Dampfkammereinrichtung aufweist.

7. Leistungsbaustein (12) nach einem der Ansprüche 3 bis 6, **dadurch gekennzeichnet, dass** der Leistungsbaustein (12) an einer Oberseite (26) des Leistungschips (18) zumindest eine fünfte Dampfkammereinrichtung (38) aufweist.

8. Leistungsbaustein (12) nach einem der vorhergehenden Ansprüche, **dadurch gekennzeichnet, dass** der Leistungschip (18) mit einer Unterseite des Leistungschips (18) an einer Fügezone (36) angeordnet ist, wobei der Leistungschip (18) und die Fügezone (36) als Oberflächen-montierbares Bauteil (20) ausgebildet sind.

9. Leistungsbaustein (12) nach Anspruch 8, **dadurch gekennzeichnet, dass** der Leistungsbaustein (12) eine metallische Komponente (38) aufweist und die Fügezone (36) mit der metallischen Komponente (38) verbunden ist.

10. Leistungsbaustein (12) nach Anspruch 9, **dadurch gekennzeichnet, dass** die metallische Komponente (38) aus Kupfer ausgebildet ist.

11. Leistungsbaustein (12) nach einem der Ansprüche 9 oder 10, **dadurch gekennzeichnet, dass** die metallische Komponente (38) mit einer Isolationsschicht (40) verbunden ist.

12. Leistungsbaustein (12) nach Anspruch 11, **dadurch gekennzeichnet, dass** die Isolationsschicht (40) aus einer Keramik ausgebildet ist.

13. Leistungsbaustein (12) nach einem der Ansprüche 11 oder 12, **dadurch gekennzeichnet, dass** die Isolationsschicht (40) mit einer weiteren metallischen Komponente (42) verbunden ist.

14. Anordnung (10) mit einem Kühlkörper (14) und mit einem Leistungsbaustein (12) nach einem der Ansprüche 1 bis 13.

15. Anordnung (10) nach Anspruch 14, **dadurch gekennzeichnet, dass** auf einer dem Kühlkörper (14) abgewandten Seite der Anordnung (10) der Leistungsbaustein (12) mit einer Leiterplatte (16) gekoppelt ist.
